Europäisches Patentamt

European Patent Office

Office européen des brevets

(19)

(11) **EP 0 906 636 B1**

(12) **EUROPEAN PATENT SPECIFICATION**

(45) Date of publication and mention
of the grant of the patent:
**25.05.2005 Bulletin 2005/21**

(51) Int Cl.⁷: **H01J 27/18**, G11B 5/72,
G11B 5/84, H01J 37/08

(21) Application number: **97927892.6**

(22) Date of filing: **29.05.1997**

(86) International application number:
**PCT/US1997/009393**

(87) International publication number:
**WO 1997/045855 (04.12.1997 Gazette 1997/52)**

(54) **HIGHLY TETRAHEDRAL AMORPHOUS CARBON FILMS AND METHODS AND ION-BEAM SOURCE FOR THEIR PRODUCTION**

HOCHTETRAEDRISCHE AMORPHE KOHLENSTOFFFILME SOWIE VERFAHREN UND IONENSTRAHLQUELLE ZUR HERSTELLUNG DERSELBEN

COUCHES DE CARBONE AMORPHE FORTEMENT TETRAHEDRIQUE ET PROCEDES DE FABRICATION ET SOURCE A RAYON D'IONS DESDITS MATERIAUX

(84) Designated Contracting States:
**AT BE CH DE DK ES FI FR GB GR IE IT LI LU MC NL PT SE**

(30) Priority: **31.05.1996 US 18793 P**
**31.05.1996 US 18746 P**
**10.12.1996 US 761336**
**10.12.1996 US 761338**

(43) Date of publication of application:
**07.04.1999 Bulletin 1999/14**

(73) Proprietor: **AKASHIC MEMORIES CORPORATION San Jose, CA 95164-0310 (US)**

(72) Inventors:
• **VEERASAMY, Vijayen**
**Farmington Hills, MI 48335-2414 (US)**
• **WEILER, Manfred**
**D-01833 Elbersdorf (DE)**
• **LI, Eric**
**Palo Alto, CA 94306 (US)**

(74) Representative: **Gesthuysen, von Rohr & Eggert Patentanwälte**
**Huyssenallee 100**
**45128 Essen (DE)**

(56) References cited:
EP-A- 0 552 491          US-A- 4 123 316
US-A- 5 017 835          US-A- 5 091 049
US-A- 5 156 703          US-A- 5 374 318
US-A- 5 466 431

• VEERASAMY V. S. ET AL.: "Electronic density of states in highly tetrahedral amorphous carbon" SOLID STATE ELECTRONICS., vol. 37, no. 2, 1994, OXFORD GB, pages 319-326, XP002041954 cited in the application
• WEILER M ET AL: "HIGHLY TETRAHEDRAL, DIAMOND-LIKE AMORPHOUS HYDROGENATED CARBON PREPARED FROM A PLASMA BEAM SOURCE" APPLIED PHYSICS LETTERS, vol. 64, no. 21, 23 May 1994, pages 2797-2799, XP000449616
• M. WEILER ET AL.: "Preparation and properties of highly tetrahedral hydrogenated amorphous carbon" PHYSICAL REVIEW, B. CONDENSED MATTER., vol. 53, no. 3, January 1996, NEW YORK US, pages 1594-1607, XP002041955 cited in the application
• OECHSNER H. ET AL.: "Electron cyclotron wave resonances and power absorption effects in electrodeless low pressure H.F. plasmas with superimposed static magnetic field " PLASMA PHYSICS., vol. 16, 1974, OXFORD GB, pages 835-844, XP002041956 cited in the application
• PATENT ABSTRACTS OF JAPAN vol. 014, no. 433 (E-0979), 17 September 1990 & JP 02 168540 A (MITSUBISHI ELECTRIC CORP), 28 June 1990,

**Description**

1. <u>Field of the Invention</u>

The present invention relates generally to thin films and methods for their deposition, and more particularly, provides diamond-like films, plasma beam deposition systems, and methods useful for production of diamond-like protective overcoats on magnetic recording media and other industrial applications.

In recent years, there has been considerable interest in the deposition of a group of materials referred to as diamond-like carbon. Diamond-like carbon can generally be defined as a metastable, high density form of amorphous carbon. Diamond-like carbon is valued for its high mechanical hardness, low friction, optical transparency, and chemical inertness.

Deposition of diamond-like carbon films often involves chemical vapor deposition techniques, the deposition processes often being plasma enhanced. Known diamond-like films often include carbon with hydrogen, fluorine, or some other agent. The durability and advantageous electrical properties of diamond-like carbon films have led to numerous proposals to apply these films to semiconductors, optics, and a wide variety of other industrial uses. Unfortunately, the cost and complexity of providing these advantageous diamond-like carbon films using known chemical vapor deposition processes has somewhat limited their use. Furthermore, while a wide variety of diamond-like carbon coating films have been deposited in laboratories, many of these films have been found to have less than ideal material characteristics.

A very different form of amorphous carbon is generally applied as a protective overcoat for magnetic recording media. Magnetic recording disks generally comprise a substrate having a magnetic layer and a number of underlayers and overlayers deposited thereon. The nature and composition of each layer is selected to provide the desired magnetic recording characteristics, as is generally recognized in the industry.

The information stored in magnetic recording media generally comprises variations in the magnetic field of a thin film of ferromagnetic material, such as a magnetic oxide or magnetic alloy. Usually, a protective layer is formed over the top of the magnetic layer, and a layer of lubricating material is deposited over the protective layer. These protective and lubricating layers combine to increase the reliability and durability of the magnetic recording media by limiting friction and erosion of the magnetic recording layer. Sputtered amorphous carbon films have gained widespread usage as protective overcoats for rigid magnetic recording disks. Sputtered amorphous carbon overcoats have been shown to provide a high degree of wear protection with a relatively thin protective layer. Magnetic recording disk structures including sputtered amorphous carbon have been very successful and allow for quite high recording densities. As with all successes, however, it is presently desired to provide magnetic recording disks having even higher recording densities.

Recording densities can generally be improved by reducing the spacing between the recording transducer, called the read/write head, and the magnetic layer of the magnetic recording disk (or more specifically, between the read/write head and the middle of the magnetic layer). In modern magnetic recording systems, the read/write head often glides over the recording surface on an air bearing, a layer of air which moves with the rotating disk. To minimize frictional contact between the rotating disk and the read/write head, the disks surface is generally rougher (and the glide height therefore higher) than would otherwise be ideal for high density magnetic recording. Even if this glide height is reduced (or eliminated), the read/write head will be separated from the recording layer by the protective amorphous carbon overcoat. This protective layer alone may, to provide the desired media life, limit the areal density of the media. Generally, overcoat layer thicknesses are dictated by durability and continuity limitations. Sputtered carbon frequently becomes discontinuous at thicknesses below about 5 nm (50Å). Thus, the durability requirements of rigid magnetic recording media generally dictate that the distance between the read/write head and the magnetic recording layer be maintained, even though this limits the areal density of the magnetic recording media.

It has previously been proposed to utilize known chemical vapor deposition techniques to deposit a variety of diamond-like carbon materials for use as protective coatings for flexible magnetic recording tapes and magnetic recording heads. Unfortunately, known methods for chemical vapor deposition of diamond-like materials, including plasma enhanced methods, generally subject the substrate to temperatures of over 500°C, which is deleterious for most magnetic disk substrates. Therefore, these known diamond-like carbon films do provide relatively good hardness and frictional properties, they have found little practical application within the field of rigid magnetic recording media, in which sputtered amorphous carbon protective overcoats are overwhelmingly dominant.

For these reasons, it would be beneficial to provide improved magnetic protective overcoats with improved read/write head frictional and glide characteristics (generally called stiction) for recording media. Preferably, such an improved overcoat will provide durability and reliability without having to resort to the density-limiting glide heights and/ or protective overcoat thickness of known rigid magnetic recording media, and without subjecting the media substrates to excessive temperatures.

It would also be desirable to provide improved diamond-like carbon materials and methods for their deposition.

It would be particularly desirable if such materials and methods could be utilized for practical rigid magnetic recording media with reduced spacing between the read/write head and the magnetic recording layer, ideally by providing a flatter, smoother, and thinner protective coating which maintained or even enhanced the durability of the total recording media structure. It would also be advantageous to provide alternative methods and systems for depositing such protective layers, for use in the production of magnetic recording media, as well as integrated circuits, optics, machine tools, and a wide variety of additional industrial applications.

2. Description of the Background Art

U.S. Patent No. 5,182,132 describes magnetic recording media having a diamond-like carbon film deposited with alternating circuit plasma enhanced chemical.vapor deposition methods. U.S. Patent No. 5,462,784 describes a fluorinated diamond-like carbon protective coating for magnetic recording media devices. European Patent Application 700,033 describes a side-mounted thin film magnetic head having a protective layer of diamond-like carbon. European Patent Application No. 595,564 describes a magnetic recording media having a diamond-like protective film which consists of carbon and hydrogen.

U.S. Patent No. 5,156,703 describes a method for the surface treatment of semiconductors by particle bombardment, the method making use of a capacitively coupled extraction grid to produce an electrically neutral stream of plasma. V.S. Veerasamy et al. described the properties of tetrahedral amorphous carbon deposited with a filtered cathodic vacuum arc in *Solid-State Electronics*, vol. 37, pp. 319-326 (1994). The recent progress in filtered vacuum arc deposition was reviewed by R.L. Boxman in a paper presented at the International Conference of Metallurgical Coatings and Thin Films located at San Diego in April of 1996. Electron cyclotron wave resonances in low pressure plasmas with a superimposed static magnetic field were described by Professor Oechsner in *Plasma* Physics, vol. 15, pp. 835-844 (1974). U.S. Patent No. 5,091,049 describes an RF ion source comprising a plasma generation chamber, an antenna to launch RF waves, magnetic means and ion extraction electrodes. Thereby, whistler waves are used to generate plasmas of high density for use in plasma etching, deposition, and sputtering equipment.

## SUMMARY OF THE INVENTION

The present invention provides an improved diamond-like carbon material as claimed in claim 1, particularly for the production of magnetic recording media. The present invention also provides a method and an ion-beam source for the deposition of such films as claimed in claims 4 and 12, respectively. The diamond-like carbon material of the present invention is highly tetrahedral, that is, it features a large number of the $sp^3$ carbon-carbon bonds which are found within a diamond crystal lattice. The material is also amorphous, providing a combination of short-range order with long-range disorder, and can be deposited as films which are ultrasmooth and continuous (pin-hole free) at thicknesses substantially lower than known amorphous carbon coating materials. The carbon protective coatings of the present invention will be hydrogenated, generally providing a significantly higher percentage of carbon-carbon $sp^3$ bonds than known hydrogenated amorphous diamond-like carbon coatings having similar compositions, and may optionally be nitrogenated. In a preferred method for depositing of these materials, capacitive coupling forms a highly uniform, selectively energized stream of ions from a dense, inductively ionized plasma. Such inductive ionization is enhanced by a relatively slow moving (or "quasi-static") magnetic field, which promotes resonant ionization and ion beam homogenization. Clearly, the materials, systems, and methods of the present invention will find applications not only in the field of magnetic recording media and related devices, but also in integrated circuit fabrication, optics, machine tool coatings, and a wide variety of film deposition and etching applications.

In one aspect, the present invention provides a method for deposition of a diamond-like amorphous highly tetrahedral carbon film, the method comprising ionizing a source material so as to form a plasma containing carbon ions. The carbon ions are energized to form a stream from the plasma toward a substrate, so that carbon from the ions is deposited on the substrate. The ions impact with an energy which promotes formation of $sp^3$ carbon-carbon bonds. Advantageously, such a method can form a highly tetrahedral amorphous carbon protective layer, generally having between 70 and 85% $sp^3$ carbon-carbon bonds. Generally, the impact energy of the energetic carbon ions is within a pre-determined range to promote formation of the desired lattice structure, the bonds apparently being formed at least in part by subplantation. Preferably, each carbon ion impacts with an energy of between about 100 and 120eV. The resulting highly tetrahedral amorphous carbon protective layer includes more than about 70% $sp^3$ carbon-carbon bonds.

Generally, the stream will be primarily composed of ions having a uniform weight, and the impact energy will preferably be substantially uniform. In some embodiments, this uniformity is promoted through filtering of the ion stream. In such cases, the energizing step generally comprises striking a plasma using a solid cathodic arc of carbon source material. Alternatively, the stream will be energized by applying an alternating potential between a coupling electrode and an extraction grid so as to self-bias the plasma relative to the extraction grid through capacitive coupling, thereby extracting the ion stream through the grid. Hydrogen and optionally nitrogen are included, both in the ion stream and the protective layer.

A magnetic recording media comprising a substrate, a magnetic layer disposed over the substrate, and a protective layer disposed over the magnetic layer may be formed. The protective layer comprises a highly tetrahedral amorphous carbon, generally having more than about 70% $sp^3$ carbon-carbon bonds. Preferably, these bonds are formed at least in part by directing an energetic stream of carbon ions onto the substrate. Such protective layers are ultrasmooth and continuous at thicknesses of less than about 7.5 nm (75Å), and will provide durable recording media even at thicknesses of less than about 5 nm (50Å). Furthermore, the hardness and tribological performance of these dense protective materials may allow highly durable recording media with areal recording densities of over 1 gigabyte per square inch with reduced read/write head glide heights of lower than about 1μ", optionally within a near-contact or continuous contact recording systems.

According to the present invention the ion beam is produced by confining a plasma within a plasma volume, inductively ionizing the plasma, and forming a stream of ions from within the plasma volume by capacitive coupling. The method may comprise moving a magnetic field through the plasma to promote resonant inductive ionization, preferably by sequentially energizing each of a plurality of coils disposed radially about the plasma volume.

In another aspect, the present invention provides an ion-beam source with an inductive ionization system. The source includes an antenna disposed about a plasma volume for inductively ionizing a plasma therein. A coupling electrode is exposed to the plasma volume and an extraction electrode is disposed over an opening of the plasma volume, so that the extraction electrode is capable of expelling ions of the plasma through the grid by capacitive coupling. The system may comprise at least one coil disposed adjacent the plasma volume capable of applying a transverse magnetic field to the plasma volume so as to promote resonant inductive ionization by the antenna. The magnetic field can be moved through the plasma container to homogenize the expelled ion stream. This movement of the magnetic field, which is optionally provided by selectively energizing coils radially disposed about the plasma volume, may also further densify the plasma by promoting particle collisions through a churning or mixing effect.

In another aspect, the present invention provides a diamond-like material comprising carbon in the range between about 72 and 92 atomic percent, and hydrogen in the range between about 8 and 18 atomic percent and having a thickness of less than about 7.5 nm. The material is amorphous, and between about 70 and 85 percent of carbon-carbon bonds are $sp^3$ bonds. Generally, $sp^3$ bond formation will be promoted with subplantation using ion-beam deposition from a plasma beam source, so that the number of such bonds will be higher than known materials having similar compositions. Hence, the highly tetrahedral amorphous carbon and hydrogenated carbon of the present invention will have fewer polymer-like hydrogen chains, and will generally exhibit enhanced thermal and mechanical stability.

According to the present invention a method for deposition of highly tetrahedral amorphous carbon over a substrate is provided, the method comprising inductively ionizing acetylene as a source material to form a plasma and confining the plasma within a plasma volume. The plasma is capacitively coupled to form a stream flowing outwardly from within the plasma volume. The stream includes carbon ions from the plasma and is directed onto the substrate. Advantageously, such a method allows deposition of carbon ions of uniform size with a uniform energy, and allows tailoring of the energetic carbon ions to specifically promote $sp^3$ bonding through subplantation. The source material typically comprises acetylene having a substantially coherent dissociation energy spectra. Preferably, the ions strike the substrate with an impact energy of between about 57 and 130 eV for each carbon atom, ideally being between about 80 and 120 eV each.

According to the present invention the ion-beam source comprises a container defining a plasma confinement volume. The container has an opening, and an antenna is disposed about the plasma volume so that application of a first alternating potential to the antenna is capable of inductively ionizing a plasma therein. A coupling electrode is electrically coupled to the plasma volume and an extraction electrode is disposed over the opening of the container. The extraction electrode has a surface area which is substantially less than the coupling electrode surface, so that application of a second alternating potential between the coupling electrode and the extraction electrode is capable of expelling ions of the plasma through the grid. Preferably, at least one coil is disposed adjacent the container, and is capable of applying a transverse magnetic field to the plasma volume, thereby promoting highly efficient inductive ionization resonance by the antenna. Ideally, the magnetic field can be moved through the plasma container to homogenize the expelled ion stream. This movement of the magnetic field, which is optionally provided by selectively energizing coils radially disposed about the plasma confinement volume, may further density the plasma by promoting particle collisions with a churning or mixing effect.

The present invention provides an ion-beam source comprising plasma containment means for confining a plasma within a plasma volume. Inductive ionization means inductively couples a first alternating current with the plasma so as to ionize the plasma within the plasma volume. Preferably, a moving magnetic field generation means provides resonant densification and homogenization of the ionized plasma within the plasma volume. Ion extraction means forms a stream of ions out from the plasma volume.

According to the present invention, an ion beam is produced by confining a plasma within a plasma volume, inductively ionizing the plasma, and forming a stream of ions from within the plasma volume by capacitively coupling the plasma with an extraction grid. This capacitive coupling self-biases the plasma relative to the grid, and can be used to produce a quasi-neutral plasma stream. Generally, a transverse magnetic field is applied to density the plasma by promoting resonant inductive ionization. Ideally, the magnetic field is moved through the plasma volume to homogenize the plasma and plasma stream.

## BRIEF DESCRIPTION OF THE DRAWINGS

Fig. 1 is a cross-sectional view of a magnetic recording disk including the tetrahedral amorphous hydrogenated carbon protective layer of the present invention.

Figs. 1A and B illustrate the effects of nitrogen doping on the tetrahedral amorphous hydrogenated carbon of the present invention.

Figs. 2 schematically illustrates a method for depositing the highly tetrahedral amorphous hydrogenated carbon over the disk of Fig. 1, and also shows a hybrid inductive/capacitive plasma beam source according to the principles of the present invention.

Fig. 2A is a cross-sectional view of the hybrid source of Fig. 2, showing the inductive ionization antenna and quasi-static magnetic field generating coils which density and homogenize the plasma.

Fig. 3A illustrates an alternative method and system for depositing highly tetrahedral amorphous hydrogenated carbon over the disk of Fig. 1 using an acetylene plasma from a plasma beam source.

Figs. 3B and C illustrate capacitive coupling of the plasma to extract a stream of ions when using the plasma beam source of Fig. 3A.

Figs. 3E and F illustrate operating characteristics of plasma beam sources for deposition of diamond-like carbon.

Figs 4A and B illustrate known resonant inductive ionization of a plasma with a fixed magnetic field.

Figs. 4C and D explain densification of the plasma provided by Electron Cyclotron Wave Resonance.

Figs. 6A-8 show experimental data, as described in detail in the experimental section.

## DESCRIPTION OF THE SPECIFIC EMBODIMENTS

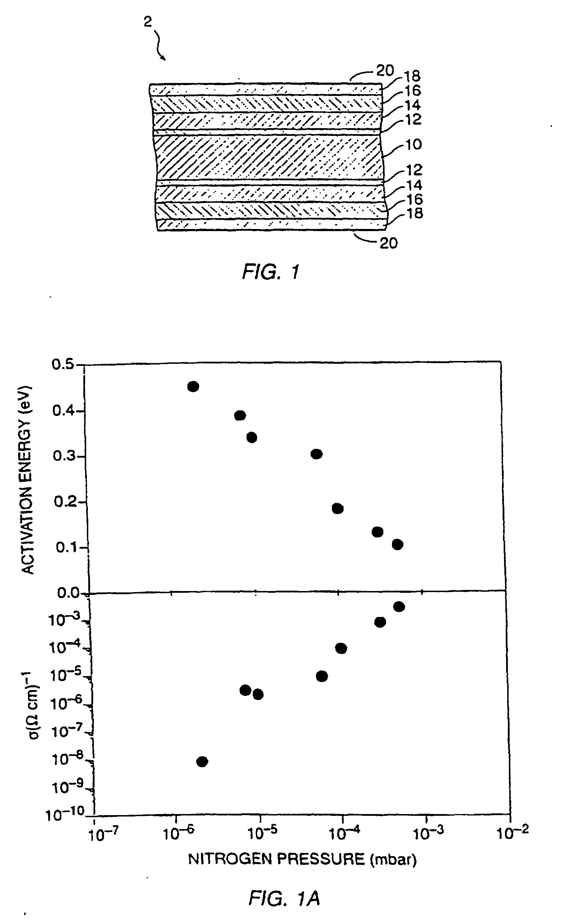

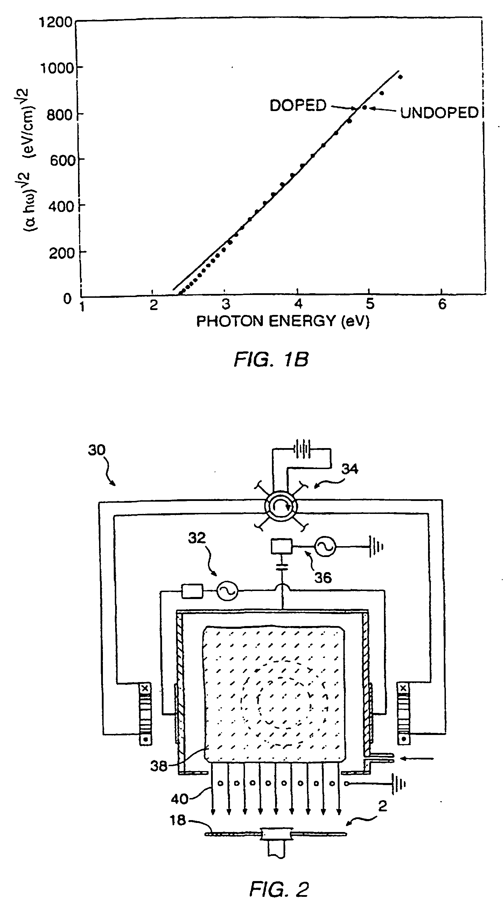

Referring now to Fig. 1, a rigid magnetic recording disk 2 comprises a non-magnetic disk substrate 10, typically composed of an aluminum alloy, glass, ceramic, a glass-ceramic composite, carbon, carbon-ceramic composite, or the like. An amorphous nickel-phosphorus (Ni-P) layer 12 is formed over each surface of the disk substrate 10, typically by plating. The Ni-P layer 12 is hard, and imparts rigidity to the aluminum alloy substrate 10. A chromium ground layer 14 is formed over Ni-P layer 12, typically by sputtering, and a magnetic layer 16 is formed over the ground layer 14. Please note that these layers are shown schematically only, as NiP layer 12 will typically be much thicker than the other layers.

The magnetic layer 16 comprises a thin film of a ferromagnetic material, such as a magnetic oxide or magnetic alloy. Magnetic layer 16 is typically sputtered over ground layer 14 in a conventional manner. The magnetic layer 16 will often be composed of a cobalt alloy, such as a CoCrTaPtB, CoCrPtB, CoCrTa, CoPtCr, CoNiCr, CoCrTaXY (X and Y being selected from Pt, Ni W, B, or other elements) or the like. The magnetic layer 16 may be formed as a single layer, or may comprise two or more layers formed over one another. The thickness of magnetic layer 16 is typically in the range from about 20 nm to 80 nm (200Å to 800Å).

Of particular importance to the present invention is a protective layer 18 which is formed over the magnetic layer 16. The protective layer 18 of the present invention will generally comprise a highly tetrahedral amorphous carbon, typically having more than about 70% $sp^3$ carbon-carbon bonds, as measured using Raman fingerprinting and electron energy loss spectroscopy. Along with carbon, protective layer 18 also includes hydrogen, forming in the range between about 8 and 18 atomic percent of the protective material. A conventional lubricating layer 20 is disposed over the protective layer 18.

Although hydrogen is known to increase the percentage of $sp^3$ bonding of diamond-like carbon produced by known chemical vapor deposition processes, protective layer 18 will generally include significantly less hydrogen than comparable known diamond-like films. This compositional difference may be explained in part by the formation of $sp^3$ bonds through subplantation of the energetic carbon ions during deposition. Effectively, the energetic ions deposited using the methods described hereinbelow impact on the growing film surface, and are driven into the film so as to cause densification. This process may also explain why the protective layer 18 of the present invention includes a higher percentage of quartenary carbon sites ($sp^3$ carbon sites with no hydrogen neighbors) and greater hardness than known alternative amorphous carbon materials.

The microstructure of conventional hydrogenated amorphous carbons includes polymer-like hydrocarbon chains. Although hydrogen enhances the formation of tetrahedrally bonded carbon atoms, above a certain threshold value of hydrogen content, carbon films become polymeric and hence lose their protective properties. Through subplantation, the materials of the present invention overcome this limitation. As subplantation promotes formation of $sp^3$ bonds without relying on additional hydrogen content alone, polymerization can be avoided. This represents a substantial advantage over known, more highly hydrogenated diamond-like carbon materials, in which polymerization significantly limits both thermal and mechanical stability. In contrast, the carbon-carbon $sp^3$ bonds of the materials of the present invention will generally be stable up to temperatures of about 700°C, so that an enhanced percentage of $sp^3$ bonds with a low hydrogen content represents a significant advantage.

Optionally, the films of the present invention may also be nitrogenated. In contrast to known hydrogenated carbon, the electrical conductivity of the present highly tetrahedral amorphous carbon can be controllably varied over a wide range by the selective incorporation of nitrogen during the $C_2H_2$ plasma beam deposition process described hereinbelow. Advantageously, this variation will be provided without significantly varying the structural properties of the film. With conventional hydrogenated carbon, nitrogen incorporation may be related to the formation of $sp^2$ bonds. This will be evident by variations in the mechanical and optical properties of the films deposited, for which harness and optical gap will decrease with nitrogen content. With the present film materials and deposition methods, a classic doping effect is observed, in which electrical conductivity can be controllably varied by as much as 5 orders of magnitude or more, as is shown in Figs. 1A and B. Doping can be provided by varying nitrogen pressure within a plasma volume of an acetylene fed plasma beam source, typically to provide films having of at least about 4 atomic percent nitrogen. This doping effect of highly tetrahedral amorphous carbon and hydrogenated carbon will find particular application for the fabrication of integrated circuits and the like.

The highly tetrahedral amorphous carbon materials of the present invention also provide a number of advantages over known protective layers for recording media. The bond structure of this material provides physical properties approaching those of diamond, including a hardness of over about 50GPa, with certain species having hardness of up to about 80GPa. Furthermore, the present protective overcoats have high density, generally being over about 2.5 grams per cubic centimeter, and are also very chemically inert.

Of particular importance to recording media, these coatings are smooth and continuous (pinhole-free) at very low thicknesses, and provide a durable protective layer when deposited to a thickness of less than 7.5 nm (75Å), preferably being less than 5 nm (50Å) thick. In fact, films of over 15 nm (150Å) may be more susceptible to delamination, and surface roughness may increase with thickness. The high mechanical hardness and low friction surfaces provided by these materials lead to enhanced tribological performance, providing recording media which are highly tolerant to the mechanical abrasion and contact start-stop demands of modern recording media systems, and allowing increased areal density through reduced separation between the read/write and the magnetic layer. This separation may be reduced by either a reduction in the protective layer thickness, or by a reduction in head glide height, and preferably by a reduction in both. Protective layer 18 is generally in the range between about 3 nm (30Å) and 7 nm (70Å), which will allow the disk to meet recording media industry durability and stiction test requirements.

The composition and characterization of the protective film of the present invention are highly dependent on the deposition method, and in particular, depend strongly on the energy and uniformity of carbon ions striking the deposition surface.

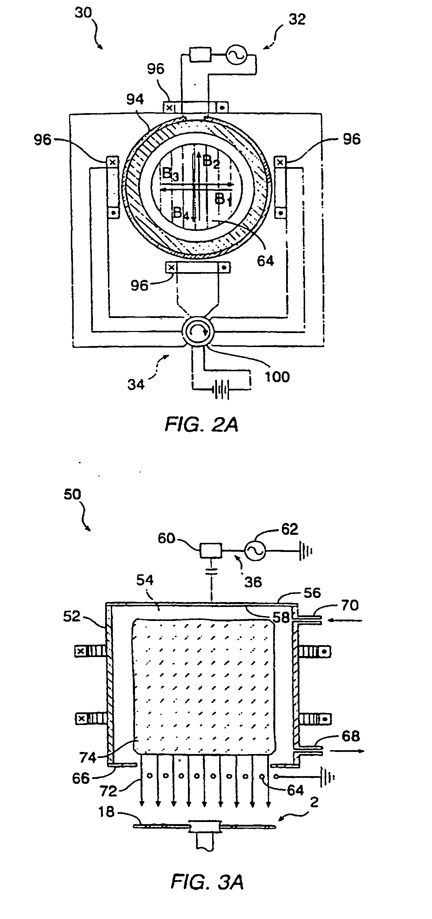

An exemplary system and method for depositing protective layer 18 on rigid recording disk 2 will be described with reference to Figs. 2 and 2A. Hybrid ion beam source 30 generally includes an inductive ionization system 32, a quasi-static magnetic field system 34, and a capacitive ion beam extraction system 36.

In general terms, induction system 32 ionizes a plasma 38. The energy transfer between induction system 32 and plasma 38 is greatly enhanced and homogenized by a transverse magnetic field generated by quasi-static field system 34. The deposition ions of plasma 38 are actually directed to recording disk 2 (or to any other substrate on which deposition is desired, or from which etching will be performed) using capacitive coupling system 36.

Although hybrid source 30 provides a particularly advantageous system for deposition of the protective coating 18, a variety of alternative deposition systems may also be used. As a plasma beam source deposition system shares a number of the features of hybrid source 30, but is simpler in operation, diamond-like carbon deposition using a plasma beam source 50 will be described with reference to Figs. 3A-F, after which other aspects of hybrid source 30 will be explained in more detail.

Referring now to Fig. 3A, the use of plasma beam source 50 for the deposition of carbon will generally be described with reference to depositing protective layer 18 on magnetic recording media 2. As has been mentioned above, these carbon deposition systems and methods will have a wide variety of alternative uses, particularly in the areas of integrated circuits fabrication, optics, and machine tools.

Plasma beam source 50 includes a plasma container 52 which defines a plasma volume 54 therein. Container 52 is typically an 8 cm diameter glass tube, or may alternatively comprise quartz or the like. A coupling electrode 56 having a relatively large surface 58 here forms one end of the container 52. Alternatively, the coupling electrode 56 may be disposed within or external to the container 52, and may optionally extend axially along the walls of the container 52. Regardless, coupling electrode 56 is generally electrically coupled to the plasma, to a matching network 60, and to a radiofrequency coupling power supply 62. Plasma coupling system 36 includes coupling electrode 56, the frequency generator and matching network 60, 62 and an extraction grid 64. Typically, the extraction grid 64 will be grounded as shown.

As is explained more fully in U.S. Patent Serial No. 5,156,703, extraction grid 64 has a much smaller surface area exposed to the plasma than the coupling electrode 56. In operation, RF power, typically at about 13.56 MHz, is supplied by the frequency generator through the matching network 60 and a capacitor to the coupling electrode 56. This frequency will often be set by government regulations, and may alternatively be about 27.12 MHz, or some other multiple thereof. The extraction grid 64 typically comprises a graphite rim 66 defining an aperture, and tungsten filaments which are maintained under tension. Hence, extraction grid 64 resists any distortion due to thermal expansion. A number of alternative materials may be used in the filaments, the filament materials preferably having a low sputtering yield.

Generally, internal pressure within plasma volume 54 is reduced by removing gas through vacuum port 68. While the vacuum port is here shown behind the grid, it will preferably be disposed between grid 64 and disk 2. Advantageously, when a plasma is struck between the coupling electrode 56 and the extraction grid 64, the plasma shifts to a positive DC potential with respect to the extraction grid 64, due to the relative mobility of the electrons as compared to the ions within the plasma. Specifically, the greater mobility of electrons than ions in the plasma causes the plasma to form a sheath between itself and each electrode 56, 64. The sheaths act as diodes, so that the plasma acquires a positive DC bias with respect to each electrode 56, 64.

The total radiofrequency potential $V_0$ will be divided between the sheaths adjacent the powered electrode and the grounded electrode, according to their respective capacitances. As the extraction electrode 64 is grounded, the voltage of the plasma itself is given by the equation

$$V = V_0 \, (C_e \, /(C_g + C_e))$$

wherein $C_e$ is the capacitance of the coupling electrode 56, while $C_g$ is the capacitance of the extraction grid 64.

Where the extraction electrode 64 is grounded, this plasma voltage biases the plasma relative to the grid 64, accelerating the ions through the extraction grid 64 and toward the substrate. As can be determined from the above equation, the plasma beam source 50 allows the biasing voltage to be selectively controlled, providing a highly advantageous mechanism for controlling ion impact energy.

As capacitance varies inversely with area, the size of the bias voltage at each electrode 56, 64 can be controlled by varying the electrode areas. As the extraction grid 64 has a much smaller area than the coupling electrode 56, the biasing of the plasma relative to the coupling electrode 56 is relatively low, so that source 50 provides a fairly efficient use of the source gas material, which is generally provided through source inlet 70 adjacent coupling electrode 56. While some material will be deposited on the container walls at higher power settings, use of the plasma beam source 50 in an etching mode may allow self cleaning.

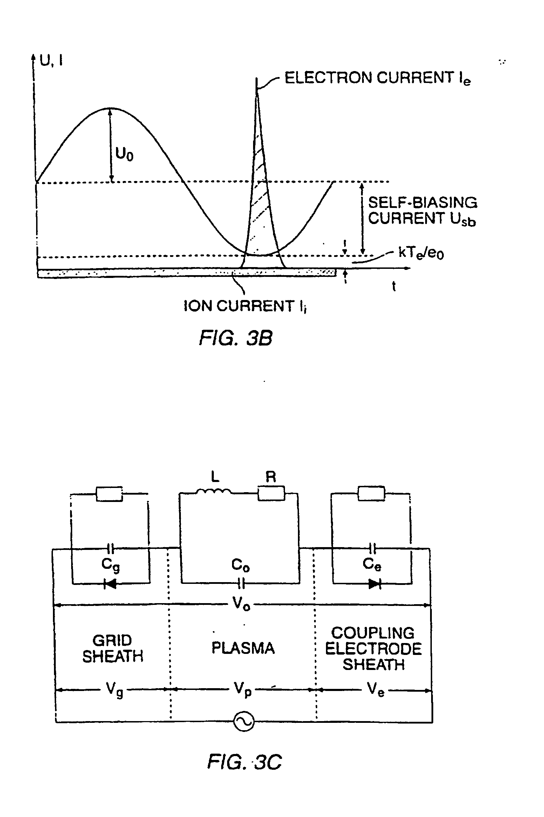

The relationship of electron current, ion current, and the radiofrequency potential is illustrated in Fig. 3B. A simplified electrical diagram for analysis of the plasma, the extraction grid sheath, and the coupling grid sheath, is shown in Fig. 3C.

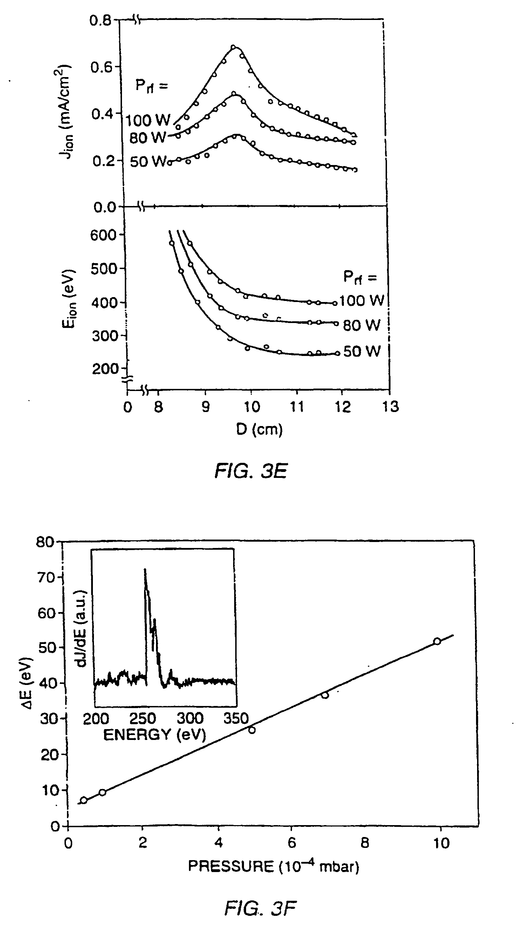

Fig. 3E shows variations of ion current and mean ion energy with electrode position D for a range of radiofrequency powers.

The ion energy depends on at least two factors: the acceleration potential across the grid sheath, and the energy lost by collisions within the sheath. The effects of these factors are illustrated in Fig. 3F.

The inset to Fig. 3F shows that the ion energy distribution of the plasma beam is quite sharp, with a width of approximately 5% about the bias voltage. The sharpness apparently arises for at least two reasons. First, ions lose little energy in the low plasma pressure through collisions within the sheath. Second, the sheath width varies inversely with the square root of pressure, so that the sheath is quite wide at low pressures. Where the ion transit time across the sheath is longer than the radiofrequency period, the ions may be accelerated by the mean voltage rather than the instantaneous voltage. The ion energy distribution width is also found to vary linearly with pressure, which indicates that the ion energy distribution width is controlled mainly by ion collisions in and above the sheath.

The decomposition or dissociation of hydrocarbons in plasma 74 depends strongly on the source gas, the operation pressure, and the gas flow rate. Usually, hydrocarbon plasmas exhibit a wide spectrum of hydrocarbon radicals in an ionized and/or neutral state. The plasma composition depends on the various chemical pathways in the plasma 74, and these depend on the plasma parameters such as electron temperature, electron density, and degree of ionization. As a result, a number of different ions may be present in the plasma 74, and the composition may change markedly under different conditions, making uniform deposition of homogeneous hydrogenated carbon materials fairly problematic.

Work in connection with the present invention has shown that acetylene provides a highly advantageous source gas because of its relatively simple dissociation pattern. The plasma decomposition of a molecule can be described in terms of electron-molecule (primary) and ion-molecule (secondary) collisions, and their associated rate coefficients or their related appearance potentials. Advantageously, the dissociation of acetylene is dominated by its ionization at an appearance potential of 11.2 eV. Acetylene may be unique among the hydrocarbons in having such a well-defined reaction path.

The ionic composition of a plasma beam produced using an acetylene source gas produces a mass spectra at various plasma pressures which are dominated by the $C_2H_2^+$ ion and other hydrocarbon ions having two carbon atoms, collectively referred to as the $C_2$ species. The next most significant ions are the $C_4$ ions, which have been found to decrease in intensity as the pressure is lowered, being below 5% if the pressure is maintained below $5 \times 10^{-5}$ mbar. For these reasons, carbon deposition using the plasma beam source and hybrid source of the present invention is performed using a feed stock which comprises acetylene. Optionally, $N_2$, $NF_3$, or some other nitrogen feedstock may also be included to provide nitrogenated films.

The particle flux or stream provided by a plasma beam deposition system or a hybrid deposition system will generally have a higher degree of ionization than conventional deposition techniques. The formation of carbon-carbon $sp^3$ bonds through the subplantation effect may only be significant if sufficient ions are present in the particle stream. Preferably, at least 15% of the particles will comprise ions. In some embodiments, particularly at very low deposition pressures, the film-forming particle flux will comprise over 90% ions.

When depositing using a plasma beam source, the incident power provided to the coupling electrode will generally be between about 50 and 700 watts, ideally being between about 200 and 300 watts. Where opposite sides of a substrate will be simultaneously coated, two plasma beam sources may be provided, preferably having independent radiofrequency generators which are phase-matched, ideally being synchronized in a master/slave configuration. Radiofrequency reflected power will generally be between about 5 and 70 watts, and should be minimized by selection of proper network elements.

The magnetic containment field coil nearest the substrate may be provided with a current of between 1 and 8 amps, ideally being about 7 amps. The outer field coil will have between one-half and 5 amps of current flowing therethrough, wherein the current is the reverse polarity of the inner coil current. Gas flow rates of from 5 sccm to 30 sccm are sufficient to maintain the plasma, with the gas flow rate ideally being about 18 sccm. Igniting the plasma is facilitated by providing an initial burst of between 40 and 50 sccm of $N_2$ gas. A nitrogen gas flow may be maintained for nitrogenation of the film.

The plasma beam source is capable of depositing ions with an energy of between about 10 eV and 500 eV, while the optimal energy for deposition of carbon is generally between about 80 and 120 eV per carbon atom. The hydrogen content may be between about 8 and 18 atomic percentage, while dopant gases of between .7 atomic percent and 10 atomic percent, typical dopant gases including $N_2$, or $PH_3$. Carbon deposition rates of between 0.2 and 1.2 nm (2 and 12Å) per second can be provided by plasma beam source deposition methods within the above operating ranges, ideally being between about 0.8 and 0.9 nm (8 and 9Å) per second to provide the highest quality films. Deposition times of between about 6 and 30 seconds are generally used at these rates to provide a sufficient protective coating for magnetic recording media. In work in connection with the present invention, M. Weiler et al. describes the preparation and properties of highly tetrahedral hydrogenated amorphous carbon deposited using a plasma beam source in the journal *Physical Review B,* vol. 53, pp. 1594-1608 (1996).

Although the plasma beam source deposition systems and methods described with reference to Fig. 3A have several advantages, including the ability to accurately control the ion deposition energy and flux, these plasma beam sources do have some disadvantages. One primary disadvantage of plasma beam source deposition is that the capacitively coupled plasma density, and hence the deposition rate, is relatively low. In order to increase the ion density, it would be beneficial to provide higher pressures within the plasma confinement volume, preferably maintaining the plasma at a pressure of 4 Pa (30 mTorr) or more. Unfortunately, the ionization coefficient tends to drop off at these higher pressures, thereby limiting the total plasma density. Specifically, it will generally be advantageous to maintain low deposition pressures for at least two reasons. First, the proportion of ions in the particle stream decreases with increasing pressures. Basically, at higher operating pressures, gas scattering will reduce and disperse the ion energy. In fact, deposition of highly tetrahedral amorphous carbon at pressures of over 4 Pa (30mTorr) when using the exemplary system is problematic, as films deposited at such pressures are formed primarily with low energy radicals. Second, as pressures increase, the particle flux increasingly includes varying particle masses ($C_2$, $C_4$, $C_6$, $C_8$...). As uniform mass particles are preferred, plasma beam deposition will preferably take place with pressures below 0,133 Pa (1mTorr), ideally at a pressure of between about 0.013 Pa and 0.064 Pa (0.1 and 0.5mTorr). This, in turn, generally limits the deposition rates which may be achieved by plasma beam sources and methods which rely solely on capacitative coupling to maintain the plasma.

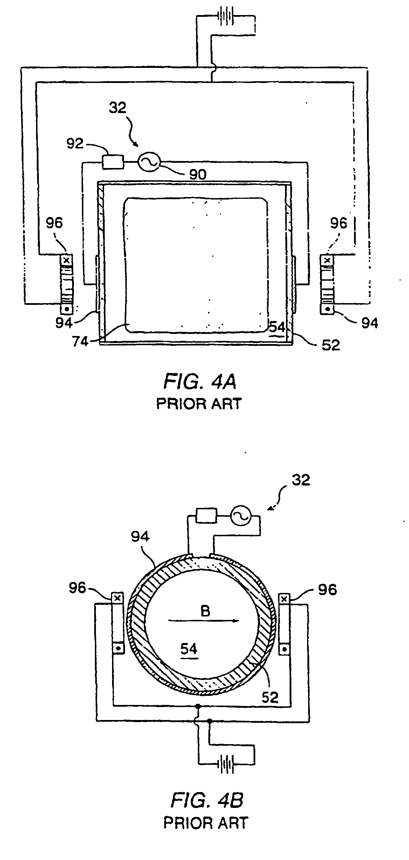

The hybrid beam source of the present invention maintains the advantageous ion energy control of the plasma beam source, but provides higher plasma densities and enhanced deposition rates without relying on increases in pressure. Referring once again to Figs. 2 and 2A, hybrid source 30 combines an inductive ionization system 32 with a capacitive coupling system 36 (similar to that used in the plasma beam sources described above) to provide a high density and low pressure plasma 38. The inductive ionization system will again be explained in isolation, here with referenced to Figs. 4A and B.

Inductive ionization system 32 comprises an alternating power source 90 capable of generating frequencies in roughly the radiofrequency-microwave range, preferably providing a potential with a frequency of about 27.12 MHz (or some multiple thereof). Once again, a frequency matching network 92 is provided, but the power is here coupled to the plasma using antenna 94 disposed around the plasma container 52. Advantageously, this minimizes any self-biasing of the plasma relative to the antenna 94, and minimizes deposition of source materials onto the walls of the container itself.

Plasma 74 within an inductive discharge may be energized in a non-resonant or resonant inductive mode. Preferably, a small DC magnetic field is superimposed on the plasma volume to provide enhanced ion energy transfer and plasma densification through a process which is generally described as resonant ionization.

Antenna 94 may be described as a dielectric wall around the axis of the plasma container 52. Alternatively, antenna 94 may be modeled as a single loop inductive coil disposed about the plasma 74. Regardless, the potential of the plasma 74 with respect to the container surface remains low, while the plasma density is quite high.

Typically, antenna 94 surrounds a cylindrical plasma container 52 having a length between one third and three times its diameter, preferably being of nearly equal length and diameter. The antenna 94 consists of a metal cylinder with a longitudinal slit. The superimposed static magnetic field B is generally normal to the axis of the plasma cylinder 52, and is applied by at least one magnetic coil 96 adjacent the plasma container 52. Resonant ionization potentials and magnetic field strengths are more fully described by Professor Oechsner in *Plasma Physics,* vol. 15, pp. 835-844 (1974).

The mechanism which will provide plasma densification will apparently be Electron Cyclotron Wave Resonance (ECWR), rather than the related but different phenomenon of Electron Cyclotron Resonance (ECR). Both of these mechanisms can be understood with reference to the dispersion of an electromagnetic wave propagating parallel to a magnetic field, and more specifically, by analyzing the refraction index and the propagating velocity (here being phase velocity Vp) as a function of frequency and magnetic field strength. We know that the refraction index and propation velocity are related as follows:

$$\frac{\omega^2}{c^2 k^2} = \frac{v_p^2}{c^2} = \frac{1}{n^2}$$

where n is the refractive index, c is the speed of light, $\omega$ is the frequency of the electromagnetic wave, and k is the magnitude of the propagation vector for the electromagnetic wave. An ordinary wave can be explained as a superposition of right- and left-handed circularly polarized electromagnetic waves. In the case of a plasma, we should also consider the different charges and masses of the electrons and ions. From the right- and left-hand polarized wave equations, we find a resonance effect is provided when $\omega$ is equal to the cyclotron frequency $\omega_c$. Under these conditions, the refraction index goes to infinity, so that the propagation velocity is zero. This condition is referred to as ECR. Unfortunately, the wavelengths associated with ECR are generally larger than the desired sizes of our plasma containers, so that practical application of ECR for plasma densification would be difficult.

Fortunately, ECWR provides an alternative densification mechanism when $\omega$ is less than $\omega_c$. Neglecting the motion of ions due to their much higher mass; the dispersion relation for the right-hand polarized wave is approximated by:

$$n_R^2 = \frac{c^2 k^2}{\omega_2} = 1 - \frac{\omega_p^2/\omega^2}{1 - (\omega_c/\omega)}$$

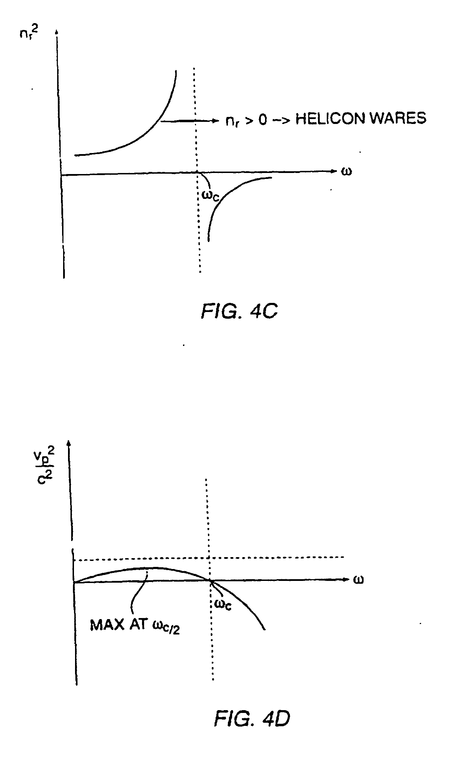

$\omega_p$ is the plasma frequency. Generally, wave propagation is possible when the phase velocity (and therefore the refractive index) is positive. Schematic plots of the refractive index of a cold plasma and the phase velocity of a cold plasma (both as a function of frequency) are given in Figs. 4C and 4D. Examination of these plots reveals that both are positive below $\omega_c$. In fact, the refractive index for a driving potential having a frequency of 13.56 MHz will reach values above 100. This means that wavelengths within the plasma may be reduced by 1/100 or more. If the wavelength can be reduced to the dimensions of the plasma container, it is possible to create standing waves in the plasma which provide a resonant effect. This ECWR will depend on the magnetic filed strength as well as the plasma container dimensions. If our plasma container has a diameter a, this resonant effect can generally be achieved if:

$$k_r = \frac{2\pi}{\lambda} = \frac{\pi}{a}(2\mu + 1)$$

$\mu = 1, 2, 3,...,$ $\lambda$ is the wavelength, and $k_r$ being the resonant magnetic field. The resonance can be tuned by varying the refractive index of the plasma. For ECWR, we will want to take into account that the refractive index for the right-hand polarized wave will depend on both the magnetic field and the plasma frequency. The variation of $n_r$ with the plasma frequency complicates this tuning somewhat, because the plasma frequency itself depends on the plasma density, which will, in turn, change with the degree of excitation of the plasma.

It is possibly to combine the densifying effects of inductive ionization on low pressure plasmas with the capacitive coupling ion beam extraction of the plasma beam source to greatly enhance deposition rates. Unfortunately, inductive ionization does not generally produce a uniform plasma density. Hence, such a hybrid deposition system, without further modification, produces a non-uniform ion stream and deposition process. For these reasons, the present invention further provides a quasi-static resonant ionization magnetic field, as will be explained with reference to Figs. 2 and 2A.

Referring once again to Fig. 2A, hybrid source 30 makes use of a plasma which is capacitively coupled so as to provide a stream of plasma ions through extraction grid 64. To promote effective capacitive coupling, the plasma is maintained at a relatively low pressure, preferably below 0,133 Pa (1 mTorr). To enhance the density of the plasma, an inductive power transfer is locally achieved using antenna 94 of inductive coupling system 32. The DC plasma potentially from capacitative coupling, and hence the ion acceleration energy, is typically about 20 to 40 volts at all surfaces. Advantageously, ion energy can be selectively controlled by varying the DC bias of the extraction grid 64, as described above. A similar combination of inductive and capacitive coupling was described for sputter treatment of dielectric samples by Dieter Martin in a 1995 dissertation for Universität Kaiserslavtern, Fachbereich Physik, Germany. That reference more fully explains the independent variation of ion energy and ion current density, similar to that applied in the hybrid deposition system of the present invention.

Ion/radical fluxes from hybrid source 30 may be enhanced using the inductive coupling system 32. To homogenize the ion stream produced by hybrid source 30, a slow moving resonant ionization magnetic field is applied by quasi-static magnetic field generation system 34.

The preferred quasi-static magnetic field generation system makes use of a plurality of coils 96 disposed radially about the plasma containment volume. Field rotator 100 selectively energizes coils 96 in opposed pairs, to apply a fairly uniform magnetic field throughout the plasma. The opposed coils 96 are energized in the same direction, but only briefly, after which an alternate pair of transverse magnetic coils 96 are energized to apply a magnetic field $B_2$. Thereafter, the original coils 96 may be reenergized, but with the opposite polarity so that magnetic field $B_3$, and then field $B_4$ are produced.

Field rotator 100 produces a magnetic field which effectively rotates through the plasma containment volume with a rotational frequency which is much less than the driving frequency of inductive coupling system 32, generally being less than 10,000 Hz, and often being less than 100 Hz. Thus, the rotating magnetic field provides resonant enhancement of the inductive coupling of a truly static resonant field. However, the rotation of the magnetic field densifies a much broader region of the plasma, and thereby provides a much more homogeneous ion stream. Moreover, the moving magnetic field may also further density the plasma by a churning effect, increasing the collisions between the energetic plasma particles to provide still further increases in deposition rate and energy transfer efficiency.

A typical hybrid source 30 will have a container volume with an internal radius of about 5 cm, and a length between the coupling electrode and the extraction grid of about 8½ cm. Such a hybrid source will require an ionizing energy of between about 100 and 1000 watts, when driven at a frequency of about 13.56 MHz (or some multiple thereof). Clearly, a wide variety of alternative container geometries and sizes may be provided, within the scope of the present invention.

When using hybrid source 30 for deposition or etching, the plasma container and deposition vessel surrounding the substrate are evacuated, preferably at a relatively high speed of about 2,000 liters per second. The ambient pressure during deposition will preferably be kept at about 50 mPa ($5 \times 10^{-4}$ mbar). Once again, a short burst of $N_2$ gas is superimposed on a steady flow of the source gas to facilitate striking of the plasma, and a gas comprising nitrogen may be continuously supplied where nitrogenation is desired. A burst on the order of a few milliseconds will suffice, or, alternatively, a high voltage pulse striker circuit may be used with similar results. Ion current densities are substantially higher than the .1 to .7 $mA/cm^2$ provided by plasma beam sources and may provide carbon deposition rates of between about 2 to 10 nm (20 to 100 Å) per second.

Although hybrid source 30 is a preferred embodiment, a wide variety of alternative systems may also be used. For example, the moving magnetic field may be provided by mechanically rotating one or more coils about the plasma containment volume.

## EXPERIMENTAL

Films were deposited on aluminum substrates over a magnetic layer using opposed plasma beam sources and acetylene plasmas. The deposition conditions are summarized in Table 1. These conditions gave a highly ionized plasma and an ion beam energy of about 120 eV/C ion within a well-defined energy window.

TABLE I

| Item | A-side | B-side | Condition |
|---|---|---|---|
| rf-input power | 250 W | 250 W | Phase-matched |
| rf-reflected power | $5 \pm 1$ W | $7 \pm 1$ W | Stable during deposition |
| Inner Coil Current | 7.0 A | 7.0 A | |
| Outer Coil Current | -0.5 A | -0.5 A | Reverse Polarity |
| Gas-flow rate | 18 sccm | 18 sccm | Plasma ignited at 43 sccm with a burst of $N_2$ gas |
| Dep-Rate | 0.8-0.9 nm/s (8-9 Å/s) | 0.8-0.9 nm/s (8-9 Å/s) | Deposition time varied from 10-30 s |

The acetylene gas flow rate was pre-set (by an electronic controller) to promote diamond-like bonding in the ta-C:H carbon films, rather than optimizing the deposition rate. Gas flow rates are in standard cubic centimeters per second (sccm). The matching-network circuit passive elements were pre-tuned so as to minimize the ratio of $P_{ref}/P_{in}$ (power reflected over power input) at the above-mentioned acetylene flow rate.

The rate phase state was triggered using a short burst of $N_2$ gas (lasting less than 0.1 s) superimposed on the steady flow of $C_2H_2$. The pressure of the chamber during deposition was in the region of 50 mPa ($5 * 10^{-4}$ mbar). Textured and untextured smooth disks were coated, and the carbon coatings were characterized using ellipsometry, electron energy loss spectroscopy (EELS) and Raman finger-printing. The textured disks were lubed using conventional lube processes, and underwent abrasive tape tests as well as accelerated start-stop tests.

Table II summarizes the variation of physical properties of the films as a function of thickness. The average ion energy per carbon ion was uniformly maintained at about 100 eV. The spatial homogeneity of the films is gauged in both the radial as well as angular positions. Generally, G-peak and D-peak are V-peak positions in Raman spectroscopy, while the associated $\Delta$ values describe peak widths. Selket voltage is the output voltage of a light sensor for abrasive wear test equipment manufactured by Selket Co. The higher the output voltage, the more serious the wear.

TABLE II

| Item | thickness (nm) $\pm$ 1 | Selket Voltage (mV) | G-peak $\pm$ 5 $cm^3$ | G-peak $\Delta$ $\pm 5$ $cm^3$ | RMS* R, (Angs) | Raman $I_d/I_g$ | Plasmon Peak (eV) |
|---|---|---|---|---|---|---|---|
| Cell 1 | 4 | 3 | 1494 | 150 | 3 | 0.24 | 31.4 |
| Cell 2 | 5 | 2 | 1498 | 152 | 4 | 0.48 | 30.0 |
| Cell 3 | 7 | 5 | 1508 | 138 | 6 | 0.5 | 29.5 |
| Cell 4 | 8 | 7 | 1507 | 137 | 6 | 0.6 | 29.8 |
| Cell 5 | 10 | 6 | 1509 | 130 | 9 | 0.7 | 29.7 |
| Cell 6 | 20 | 7 | 1509 | 130 | 8 | 1.0 | 25.5 |

One noteworthy observation from the Raman spectra is the increase in both the position of the G-peak as well as the $I_d/I_g$ ratio (the area ratio of the D and G peaks) with increasing film thickness. This shows that the percentage of C-C $sp^3$ content in the bulk of the films increases with decreasing thickness. D-peak bandwidth also increases with decreasing film thickness within the range monitored. The bandwidth of the D-peak in the optimized films is above 150 $cm^{-1}$, indicating very low levels (or absence) of graphitic phase clustering within the diamond-like carbon amorphous matrix. This result is consistent with the relatively high Plasmon-peak measured from the electron-energy-loss-spectroscopy (EELS). Plasmon peak is the energy of a type of excitation called a plasmon. It is a quantum of charged particle cloud vibration. The energy value is directly related to the charged particle (e.g., electron) density.

The Plasmon-peak $E_p$ is representative of the density of the films. Thus, taking the $E_p$ of diamond to be 34 eV, it is estimated that the most-diamond-like ta-C:H films have above 80 % C-C sp$^3$ bonding (this is independent of whether there is long range order or not).

Disks were coated with ta-C:H films under a wide variety of rf-power and gas-feedstock flow rates. These films were then tested for friction build-up and wear durability using a conventional accelerated contact start/stop (CSS) test. Prior to testing, the disks were lubed and lube thickness was found to vary between 1.6-2.3 nm (16-23 Å), corresponding to a carbon film thickness range of 3 nm to 15 nm (30 Å to 150 Å). Each test consisted of 500 cycles, and the disks were tested on both sides at 300 rpm. The averaged coefficients of friction ($\mu_s$) are plotted against thickness of the films in Table III. The variation of $\mu_s$ is found to be between 0.5 to 1.5 corresponding to a thickness range from 4 nm to 15 nm (40 Å to 150 Å). Of the 16 disks that underwent the accelerated CSS test, all but one passed.

TABLE III

| rf power (Watts) | Gas flow-rate (sccm) | Deposition time(s) | Coefficient of static friction $\mu_s$ |
|---|---|---|---|
| 500 | 20 | 10 | 1.6 |
| 100 | 12 | 30 | 1.8 |
| 500 | 20 | 6 | 1.5 |
| 100 | 20 | 6 | 1.6 |
| 300 | 16 | 6 | 1.4 |
| 500 | 20 | 6 | 1.5 |
| 500 | 20 | 30 | 2.0 |
| 500 | 20 | 12 | 1.5 |
| 500 | 20 | 6 | 1.9 |
| 100 | 12 | 6 | 1.7 |
| 100 | 12 | 6 | 1.6 |
| 100 | 12 | 30 | 1.6 |
| 100 | 16 | 18 | 1.5 |
| 300 | 16 | 6 | 1.3 |

Disks were also coated with highly tetrahedral amorphous carbon using a filtered cathodic arc. Initially, two disks were coated with a static ion stream, producing coatings which varied considerably from the center to the edge. Estimating coating thicknesses using interference colors, and assuming an index of refraction of 2.5 coating thicknesses varied at least between 0.125 nm and 50 nm (1,250 Å and 500 Å).

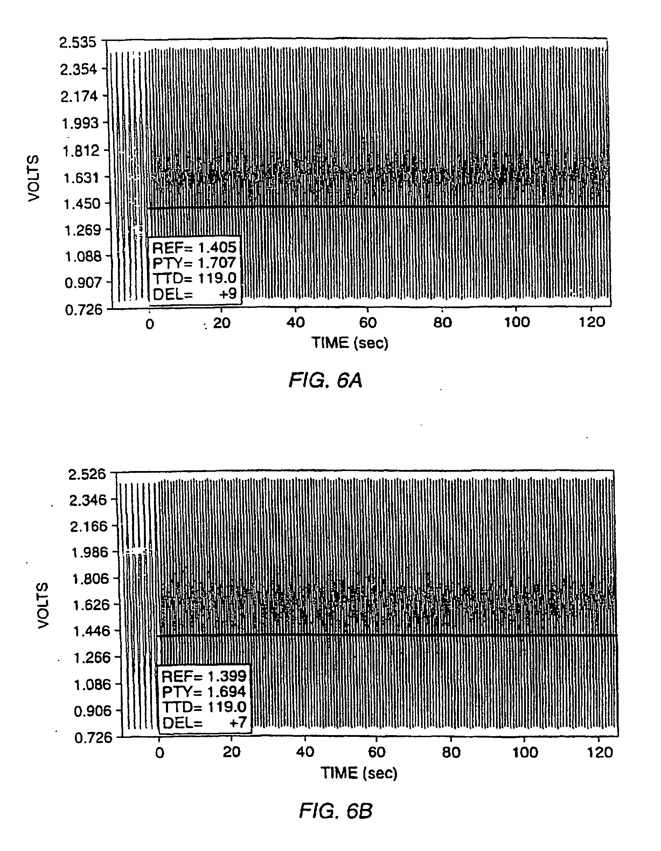

Raw data from Selket abrader tests are provided in Figs. 6A and B. Over the two 120 second tests, no debris was seen on the tape. Only a very faint wear track was found after tests were complete.

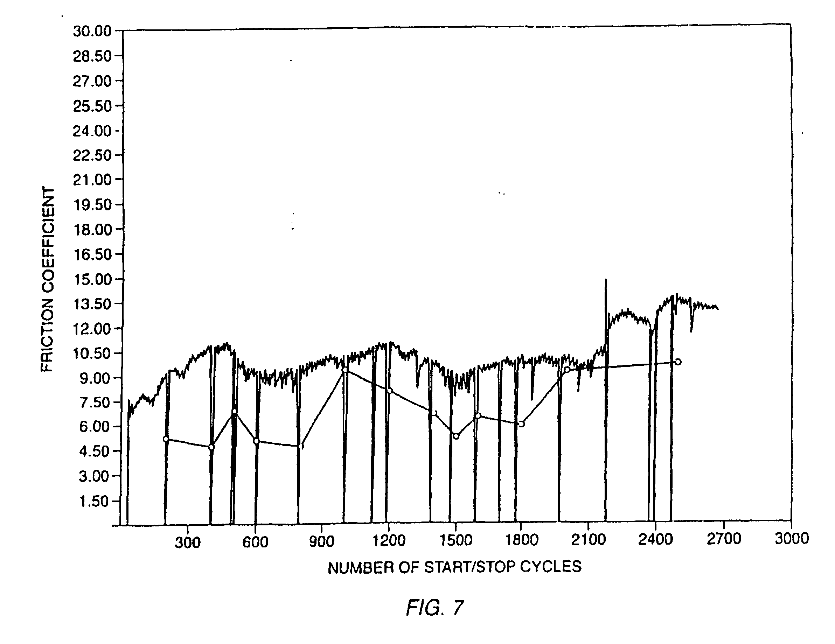

Peak friction of the disks was also measured as a function of the number of start/stop cycles. The results of these tests are provided in Fig. 7.

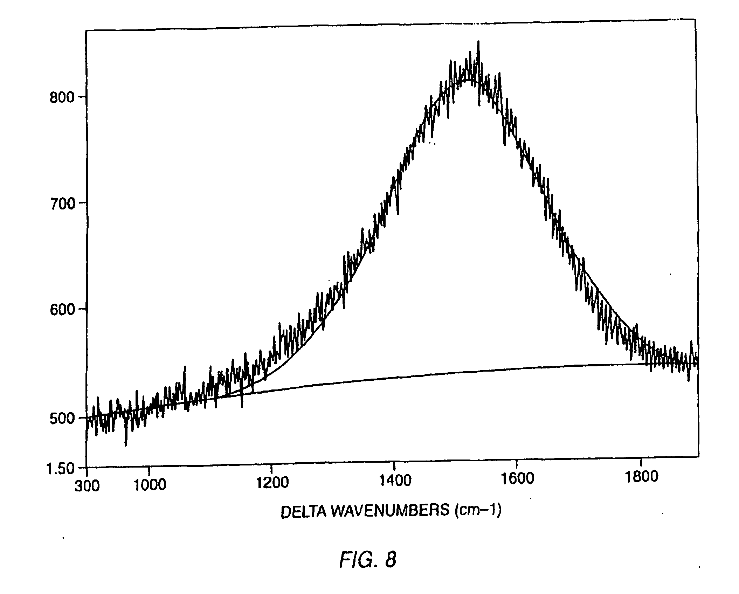

The Raman spectra of the filtered cathodic arc disks were also measured, and the results are provided in Fig. 8. Generally, these results indicate that a film can be deposited using a cathodic arc source which includes a G-peak in the area of about 1518, and having a G width of approximately 175. The pseudo band gap of this film appears to be roughly 1.68 eV, while the refractive index is approximately 2.5. The complex portion of the optical index of refraction, K, appears to be approximately .08 for the film.

An additional disk was coated, this time on both sides, using a filtered cathodic arc source. The ion stream was swept over the surface of the substrate by manipulating permanent magnets placed on either side of the chamber. No bias was applied to the scanned substrate. Although the scanning mechanism here was quite simple, a more uniform deposition layer was provided.

**Claims**

1.   A diamond-like amorphous highly tetrahedral carbon film, said film being pin-hole free and comprising carbon in the range of between 72 and 92 atomic percent and hydrogen in the range of between 8 and 18 atomic percent and having a thickness of less than about 7.5 nm (75 Å), wherein between 70 and 85 % of the carbon-carbon bonds of said film are $sp^3$ bonds.

2. Carbon film according to claim 1, said film having a thickness of less than 5.0 nm (50 Å).

3. Carbon film according to claim 1 or 2, said film comprising at least 4 atomic percent of nitrogen.

4. A method for deposition of the diamond-like amorphous highly tetrahedral carbon film according to claims 1 to 3 onto a substrate, said method comprising:

   inductively ionizing acetylene to form a plasma;

   confining the plasma within a plasma volume;

   capacitatively coupling the plasma between a coupling electrode and an extraction electrode to form a stream flowing outwardly from within the plasma volume, the stream including carbon ions from the plasma; and

   directing the stream onto the substrate.

5. A method according to claim 4, wherein the impact energy is between 57 and 130 eV for each carbon atom.

6. A method according to claim 4, wherein the impact energy is between 80 and 120 eV for each carbon atom.

7. A method according to claims 4 to 6, said method further comprising moving a magnetic field through the plasma volume to promote even resonant inductive ionization and to homogenize the ion stream.

8. A method according to claim 7, wherein moving the magnetic field comprises selectively energizing magnetic coils disposed about the plasma volume.

9. A method according to claim 7 or 8, wherein the magnetic field rotates through the plasma volume with a frequency which is much less than the frequency of an alternating induction potential.

10. A method according to claims 7 to 9, wherein the magnetic field is transverse and rotates about an axis which is substantially normal to a capacitively coupled extraction grid.

11. A method according to claims 7 to 10, wherein the magnetic field rotates with a frequency of less than 10 kHz.

12. An ion-beam source (30, 50) for the deposition of diamond-like amorphous highly tetrahedral carbon films (18) onto a substrate (2), said ion-beam source comprising:

    a container (52) defining a plasma confinement volume (54), said container (52) having an opening;

    an antenna (94) disposed about said plasma volume (54) so that application of a first alternating potential to said antenna (94) is capable of inductively ionizing a plasma (38, 74) therein; and

    an extraction electrode (64) comprising a grid and being disposed over said opening of the container (52),

    **characterized in**
    **that** said ion-beam source (30, 50) also comprises a coupling electrode (56) being exposed to said plasma volume (54) and being electrically coupled to said plasma volume (54); and
    **that** said extraction electrode (64) has a surface area which is substantially less than the coupling electrode surface so that application of a second alternating potential between said coupling electrode (56) and said extraction electrode (64) is capable of expelling ions of said plasma through the capacitively coupled grid.

13. An ion-beam source according to claim 12, said ion-beam source (30, 50) further comprising at least one coil (96) disposed adjacent to the container (52) and capable of applying a magnetic field to the plasma volume (54), the magnetic field being transverse relative to an axis through the opening.

14. An ion-beam source according to claim 13, said ion-beam source (30, 50) further comprising a plurality of coils (96) disposed about the container (52) so that the magnetic field can be moved within the plasma volume (54) by selectively energizing one or more coils (96).

15. An ion-beam source according to claim 14, wherein the plurality of coils (96) is radially disposed about the plasma confinement volume (54).

16. An ion-beam source according to claims 12 to 15, wherein the plasma confinement volume (54) substantially defines a length and a diameter, wherein the opening is disposed at one end of the length, and wherein the length is between about one third the diameter and three times the diameter.

17. An ion-beam source according to claims 12 to 16, wherein the container (52) comprises an electrically non-conductive material.

18. An ion-beam source according to claim 17, wherein the antenna (94) comprises a single coil (96) separated from the plasma volume (54) by the non-conductive material.

19. A deposition system comprising:

an ion-beam source (30, 50) according to one of the claims 12 to 18;

an RF potential supply (32) coupled to the inductive coupling antenna (94);

a field potential supply (34) couplable to the at least one coil (96) to provide a magnetic field within the plasma volume (54); and

an extraction power supply (36) coupled to the coupling electrode (56) and the extraction electrode (64).

**Patentansprüche**

1. Diamantähnlicher (diamantartiger), amorpher hochtetraedrischer Kohlenstoffilm (Kohlenstoffschicht), wobei der Film frei von Fehlstellen (Pin-holes) ist und Kohlenstoff im Bereich von 72 bis 92 Atom-% und Wasserstoff im Bereich von 8 bis 18 Atom-% aufweist und eine Dicke von weniger als etwa 7,5 nm (75 Å) aufweist, wobei 70 bis 85 % der Kohlenstoff-Kohlenstoff-Bindungen des Films $sp^3$-Bindungen sind.

2. Kohlenstoffilm nach Anspruch 1, wobei der Film eine Dicke von weniger als 5,0 nm (50 Å) aufweist.

3. Kohlenstoffilm nach Anspruch 1 oder 2, wobei der Film mindestens 4 Atom-% Stickstoff aufweist.

4. Verfahren zur Abscheidung bzw. Auftragung von diamantähnlichen, amorphen hochtetraedrischen Kohlenstoffilmen gemäß einem der Ansprüche 1 bis 3 auf einem Substrat, wobei das Verfahren umfaßt:

- induktive Ionisierung von Acetylen zur Bildung eines Plasmas;

- Eingrenzung des Plasmas in einem Plasmavolumen;

- kapazitive Kopplung des Plasmas zwischen einer Kopplungselektrode und einer Extraktionselektrode zur Bildung eines aus dem Plasmavolumen hinausfließenden Stroms, wobei der Strom Kohlenstoffionen aus dem Plasma enthält; und

- Ausrichtung des Stroms auf das Substrat.

5. Verfahren nach Anspruch 4, wobei die Aufschlagenergie (Einschlagenergie) für jedes Kohlenstoffatom 57 bis 130 eV beträgt.

6. Verfahren nach Anspruch 4, wobei die Aufschlagenergie für jedes Kohlenstoffatom 80 bis 120 eV beträgt.

7. Verfahren nach einem der Ansprüche 4 bis 6, wobei das Verfahren weiterhin die Bewegung eines Magnetfeldes durch das Plasmavolumen zur Unterstützung auch einer resonanten induktiven Ionisierung und zur Homogenisierung des Ionenstroms umfaßt.

8. Verfahren nach Anspruch 7, wobei die Bewegung des Magnetfelds eine selektive Anregung von um das Plasmavolumen angeordneten Magnetspulen umfaßt.

9. Verfahren nach Anspruch 7 oder 8, wobei das Magnetfeld durch das Plasmavolumen mit einer Frequenz rotiert, welche viel kleiner als die Frequenz eines alternierenden Induktionspotentials ist.

10. Verfahren nach einem der Ansprüche 7 bis 9, wobei das Magnetfeld transversal verläuft und um eine Achse, welche im wesentlichen senkrecht zu einem kapazitiv gekoppelten Extraktions- bzw. Auslaßgitter ist, rotiert.

11. Verfahren nach einem der Ansprüche 7 bis 10, wobei das Magnetfeld mit einer Frequenz von weniger als 10 kHz rotiert.

12. Ionenstrahlquelle (30, 50) zur Abscheidung bzw. Auftragung von diamantähnlichen, amorphen hochtetraedrischen Kohlenstoffilmen (18) auf einem Substrat (2), wobei die Ionenstrahlquelle umfaßt:

- ein Gehäuse (52), welches ein plasmaeingrenzendes Volumen (54) definiert, wobei das Gehäuse (52) eine Öffnung aufweist;

- eine Antenne (94), welche um das Plasmavolumen (54) angeordnet ist, so daß das Anlegen bzw. die Applikation eines ersten alternierenden Potentials an dieser Antenne (94) zu einer induktiven Ionisierung eines darin befindlichen Plasmas (38, 74) führt; und

- eine Extraktionselektrode (64), welche ein Gitter umfaßt und über der Öffnung des Gehäuses (52) angeordnet ist,

**dadurch gekennzeichnet,**
**daß** die Ionenstrahlquelle (30, 50) auch eine Kopplungselektrode (56) aufweist, welche dem Plasmavolumen (54) ausgesetzt und elektrisch mit dem Plasmavolumen (54) gekoppelt ist; und
**daß** die Extraktionselektrode (64) eine Oberfläche aufweist, welche im wesentlichen kleiner als die Oberfläche der Kopplungselektrode ist, so daß das Anlegen eines zweiten alternierenden Potentials zwischen der Kopplungselektrode (56) und der Extraktionselektrode (64) imstande ist, Ionen des Plasmas durch das kapazitiv gekoppelte Gitter auszustoßen.

13. Ionenstrahlquelle nach Anspruch 12, wobei die Ionenstrahlquelle (30, 50) weiterhin mindestens eine an das Gehäuse (52) angrenzende Spule (96) aufweist, die imstande ist, ein Magnetfeld an bzw. auf das Plasmavolumen (54) anzulegen, wobei das Magnetfeld transversal in bezug auf eine Achse durch die Öffnung ist.

14. Ionenstrahlquelle nach Anspruch 13, wobei die Ionenstrahlquelle (30, 50) weiterhin eine Mehrzahl von um das Gehäuse (52) angeordneten Spulen (96) aufweist, so daß das Magnetfeld in dem Plasmavolumen (54) durch selektive Anregung einer oder mehrerer Spulen (96) bewegt werden kann.

15. Ionenstrahlquelle nach Anspruch 14, wobei die Mehrzahl von Spulen (96) radial um das das Plasma eingrenzende Volumen (54) angeordnet ist.

16. Ionenstrahlquelle nach einem der Ansprüche 12 bis 15, wobei das das Plasma eingrenzende Volumen (54) im wesentlichen eine Länge und einen Durchmesser definiert, wobei die Öffnung an einem Längsende angeordnet ist und wobei die Länge von etwa ein Drittel des Durchmessers bis etwa das Dreifache des Durchmessers beträgt.

17. Ionenstrahlquelle nach einem der Ansprüche 12 bis 16, wobei das Gehäuse (52) ein elektrisch nichtleitendes Material umfaßt.

18. Ionenstrahlquelle nach Anspruch 17, wobei die Antenne (94) eine einzelne Spule (96), die von dem Plasmavolumen (54) durch das nichtleitende Material separiert ist, umfaßt.

19. Abscheidungs- bzw. Auftragungssystem, umfassend:

- eine Ionenstrahlquelle (30, 50) gemäß einem der Ansprüche 12 bis 18;

- eine RF-Potentialversorgung (32), welche mit der induktiv koppelnden Antenne (94) gekoppelt ist;

- eine Feldpotentialversorgung (34), welche mit mindestens einer Spule (96) koppelbar ist, um ein Magnetfeld in dem Plasmavolumen (54) bereitzustellen; und

- eine Extraktionsspannungsversorgung (36), welche mit der Kopplungselektrode (56) und der Extraktionselektrode (64) gekoppelt ist.

**Revendications**

1. Film à haute teneur en carbone tétraédrique, amorphe et analogue au diamant, ledit film étant exempt de lacunes de discontinuité, comprenant du carbone en concentration atomique comprise entre 72 et 92 % et de l'hydrogène en concentration atomique comprise entre 8 et 11 % et présentant une épaisseur inférieure à 7,5 nm (75 Å) environ, **caractérisé en ce que** de 70 à 85 % des liaisons carbone-carbone dudit film sont des liaisons $sp^3$.

2. Film de carbone selon la revendication 1, **caractérisé en ce qu'**il présente une épaisseur inférieure à 5,0 nm (50 Å).

3. Film de carbone selon la revendication 1 ou 2, **caractérisé en ce qu'**il comprend au moins 4 % d'atomes d'azote.

4. Procédé pour déposer le film à haute teneur en carbone tétraédrique, amorphe et analogue au diamant selon l'une des revendications 1 à 3 sur un substrat, ledit procédé comportant les étapes suivantes :

    ioniser, par mode inductif, de l'acétylène pour former un plasma ;

    confiner le plasma à l'intérieur d'un volume plasmique ;

    coupler, selon un mode capacitif, le plasma entre une électrode de couplage et une électrode d'extraction afin de former un flux s'écoulant vers l'extérieur à partir de l'intérieur du volume plasmique, le flux renfermant des ions carbone issus du plasma ; et

    diriger le flux sur le substrat.

5. Procédé selon la revendication 4, **caractérisé en ce que** l'énergie d'impact sur le substrat est comprise entre 57 et 130 eV pour chaque atome de carbone.

6. Procédé selon la revendication 4, **caractérisé en ce que** l'énergie d'impact sur le substrat est comprise entre 80 et 120 eV pour chaque atome de carbone.

7. Procédé selon l'une des revendications 4 à 6, **caractérisé en ce qu'**il comporte en outre l'étape consistant à déplacer un champ magnétique à travers le volume plasmique afin de promouvoir son ionisation régulière par mode inductif résonant et d'homogénéiser le flux ionique.

8. Procédé selon la revendication 7, **caractérisé en ce que** le déplacement du champ magnétique comporte l'excitation sélective de bobines magnétiques disposées autour du volume plasmique.

9. Procédé selon la revendication 7 ou 8, **caractérisé en ce que** le champ magnétique tourne à travers le volume plasmique selon une fréquence qui est bien inférieure à la fréquence d'un potentiel alternatif d'induction.

10. Procédé selon l'une des revendications 7 à 9, **caractérisé en ce que** le champ magnétique est transversal à et tourne autour d'un axe qui est substantiellement normal à une grille d'extraction en couplage par mode capacitif.

11. Procédé selon l'une des revendications 7 à 10, **caractérisé en ce que** le champ magnétique tourne selon une fréquence inférieure à 10 kHz.

12. Source de faisceau ionique (30, 50) pour le dépôt de films (18) à haute teneur en carbone tétraédrique, amorphes et analogues au diamant sur un substrat (2), du type comprenant :

une enceinte (52) définissant un volume de confinement plasmique (54) et présentant une ouverture ;

une antenne (94) disposée autour dudit volume plasmique (54) de telle façon que l'application d'un premier potentiel alternatif à ladite antenne (94) soit capable d'ioniser par mode inductif un plasma (38, 74) ; et

une électrode d'extraction (64) comprenant une grille et disposée sur ladite ouverture de l'enceinte (52),

**caractérisée en**
**ce que** ladite source de faisceau ionique (30, 50) comprend également une électrode de couplage (56) disposée en regard dudit volume plasmique (54) et couplée électriquement audit volume plasmique (54) ; et
**en ce que** ladite électrode d'extraction (64) présente une aire de surface qui est substantiellement plus petite que la surface de l'électrode de couplage, de telle façon que l'application d'un second potentiel alternatif entre ladite électrode de couplage (56) et ladite électrode d'extraction (64) soit capable d'éjecter des ions dudit plasma au travers de la grille en couplage par mode capacitif.

13. Source de faisceau ionique (30, 50) selon la revendication 12, **caractérisée en ce qu'**elle comprend en outre au moins une bobine (96) disposée au voisinage de l'enceinte (52) et capable d'appliquer un champ magnétique au volume plasmique (54), ledit champ magnétique étant transversal par rapport à un axe passant à travers l'ouverture.

14. Source de faisceau ionique (30, 50) selon la revendication 13, **caractérisée en ce qu'**elle comprend en outre une pluralité de bobines (96) disposées autour de l'enceinte (52) de telle façon que le champ magnétique puisse être déplacé à l'intérieur du volume plasmique (54) en excitant sélectivement une ou plusieurs bobines (96).

15. Source de faisceau ionique (30, 50) selon la revendication 14, **caractérisée en ce que** la pluralité de bobines (96) est en disposition radiale autour du volume de confinement plasmique (54).

16. Source de faisceau ionique (30, 50) selon l'une des revendications 12 à 15, **caractérisée en ce que** le volume de confinement plasmique (54) définit substantiellement une longueur et un diamètre, selon lesquels l'ouverture est disposée à une extrémité de ladite longueur et selon lesquels ladite longueur est comprise environ entre un tiers du diamètre et trois fois le diamètre.

17. Source de faisceau ionique (30, 50) selon l'une des revendications 12 à 16, **caractérisée en ce que** l'enceinte (52) comprend un matériau électriquement non conducteur.

18. Source de faisceau ionique (30, 50) selon la revendication 17, **caractérisée en ce que** l'antenne (94) comprend une bobine unique (96) séparée du volume plasmique (54) par le matériau non conducteur.

19. Système de dépôt sur un substrat comprenant :

une source de faisceau ionique (30, 50) selon l'une des revendications 12 à 18 ;

une alimentation en potentiel RF (32) couplée à l'antenne de couplage par mode inductif (94) ;

une alimentation en potentiel de champ (34) susceptible d'être couplée à au moins une bobine (96) afin de fournir un champ magnétique à l'intérieur du volume plasmique (54) ; et

une alimentation en énergie d'extraction (36) couplée à l'électrode de couplage (56) et à l'électrode d'extraction (64).

FIG. 1

FIG. 1A

FIG. 1B

FIG. 2

FIG. 2A

FIG. 3A

**ELECTRON CURRENT $I_e$**

$U, I$

$U_0$

**SELF-BIASING CURRENT $U_{sb}$**

$kT_e/e_0$

$t$

**ION CURRENT $I_i$**

*FIG. 3B*

L    R

$C_g$        $C_o$        $C_e$

$V_o$

GRID SHEATH        PLASMA        COUPLING ELECTRODE SHEATH

$V_g$        $V_p$        $V_e$

*FIG. 3C*

FIG. 3E

FIG. 3F

FIG. 4A
PRIOR ART

FIG. 4B
PRIOR ART

23

FIG. 4C

FIG. 4D

*FIG. 6A*

*FIG. 6B*

*FIG. 7*

*FIG. 8*

EP 0 906 636 B1